Europäisches Patentamt

European Patent Office

Office européen des brevets

(19)

(11) Veröffentlichungsnummer: **0 346 751 B1**

(12) **EUROPÄISCHE PATENTSCHRIFT**

(45) Veröffentlichungstag der Patentschrift: **25.08.93**

(51) Int. Cl.5: **H04N 7/137**

(21) Anmeldenummer: **89110291.5**

(22) Anmeldetag: **07.06.89**

(54) **Anordnung zur DPCM-Codierung von Fernsehsignalen.**

(30) Priorität: **14.06.88 DE 3820233**

(43) Veröffentlichungstag der Anmeldung:
**20.12.89 Patentblatt 89/51**

(45) Bekanntmachung des Hinweises auf die
Patenterteilung:
**25.08.93 Patentblatt 93/34**

(84) Benannte Vertragsstaaten:
**DE FR GB IT**

(56) Entgegenhaltungen:
**GB-A- 2 003 001**
**US-A- 4 200 886**

**Proceedings of the IEEE Band 73, Nr. 4, April
1985, Seiten 592-598, New York, US; P.
Pirsch: "Design of a DPCM Codec for VISI
Realization in CMOS Technology".**

(73) Patentinhaber: **SIEMENS AKTIENGESELL-
SCHAFT**
**Wittelsbacherplatz 2**
**D-80312 München(DE)**

(72) Erfinder: **Mattausch, Hans-Jürgen, Dr. rer. nat.**
**Am Brunnen 25**
**D-8011 Kirchheim(DE)**
Erfinder: **Matthiesen, Fred, Dipl.-Ing.**
**Kolumbusstrasse 19**
**D-8000 München 90(DE)**
Erfinder: **Schöbinger, Matthias, Dr. phil. nat.**
**Schleissheimer Strasse 71**
**D-8000 München 40(DE)**

EP 0 346 751 B1

## Beschreibung

Die Erfindung bezieht sich auf eine Anordnung zur DPCM-Signalcodierung von Fernsehsignalen nach dem Oberbegriff des Patentanspruchs 1 und des Patentanspruches 2.

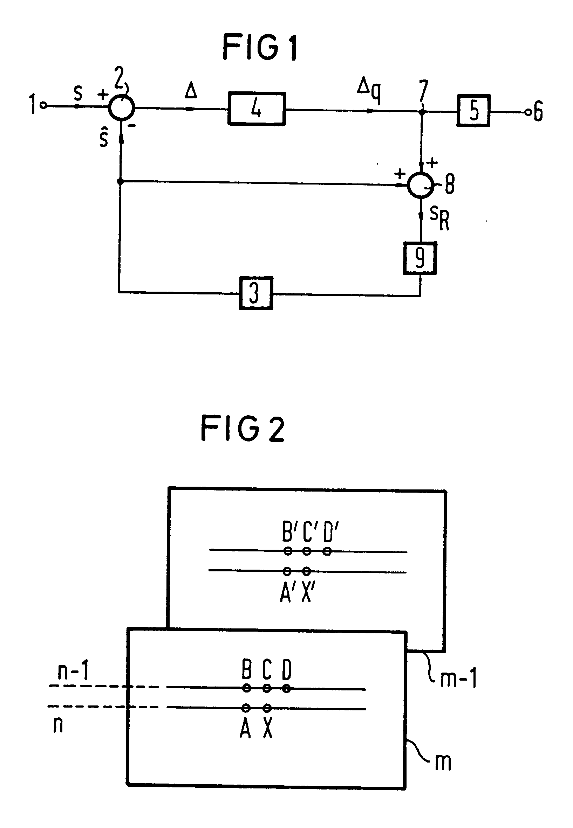

Eine Anordnung dieser Art, die zum Beispiel aus den Proc. IEEE Bd. 73, Nr. 4, April 1985, Seiten 592 bis 598, vgl. dort insbesondere Figuren 1, 2 und 4, bekannt ist, sei anhand eines in Figur 1 dargestellten Prinzipschaltbildes erläutert. Dabei liegt an einem Eingang 1 der Anordnung eine Folge von digitalisierten Bildpunktsignalen s an, die über im einzelnen nicht dargestellte Abtast- und Haltestufen zugeführt werden. Zur Reduktion des Datenflusses bemüht man sich, redundante und irrelevante Anteile des Bildsignals herauszunehmen, um beispielsweise die Bitübertragungsrate senken zu können, ohne die Bildqualität hierdurch zu verschlechtern. Im einzelnen geschieht dies dadurch, daß nicht die aufeinanderfolgenden Bildpunktsignale über den zu einer Empfangsstelle führenden Übertragungskanal übertragen werden, sondern nur die Differenzsignale, die durch eine Differenzbildung zwischen jeweils einem aktuellen Bildpunktsignal s und einem aufgrund der vorausgegangenen Bildpunktsignale in einem Prädiktor ermittelten Schätzwert $\hat{s}$ gebildet werden. Ein solches Verfahren wird auch als Differenz-Pulscodemodulation (DPCM) bezeichnet.

Die Patentanmeldung EP-A-O 288 783 (Stand der Technik nach Art 54(3) EPÜ "Anordnung zur DPCM-Codierung von Fernsehsignalen" zeigt einen DPCM-Codierer, bei dem von digitalisierten Bildpunktsignalen jeweils Schätzwerte subtrahiert werden und die Schätzfehler nach Quantisierung und Codierung zur Signalübertragung verwendet werden. Jeder Schätzwert wird aus einem in einem Addierer gebildeten rekonstruierten Bildpunktsignal abgeleitet. Dabei finden getrennte gleichzeitige Subtraktionen des am Addierausgang abgegriffenen Signals sowie des positiven und des negativen Addierergrenzwertes jeweils vom eingangsseitigen Bildpunktsignal statt, wobei eine Überlauferkennungseinrichtung und ein Multiplexer dafür sorgen, daß von den drei insoweit gebildeten Differenzen jeweils nur die von dem tatsächlichen Additionsergebnis (kein Überlauf, positiver Überlauf, negativer Überlauf) Rechnung tragende Differenz an dem Quantisierer durchgeschaltet wird. Ein die Rechengeschwindigkeit verringernder Begrenzer zwischen zwei Addierern kann hierbei dadurch entfernt werden, indem die Begrenzerfunktion auf drei parallel rechnende Pfade für den positiven und negativen Addiergrenzwert sowie den unbegrenzten Wert verteilt wird. Für die drei parallel rechnenden Pfade sind in dieser Anordnung drei Subtrahierer erforderlich, was einen erhöhten Schaltungsaufwand bedeutet.

Die für eine DPCM-Codierung erforderliche Differenzbildung geschieht in einem Subtrahierer 2, dessen erster Eingang mit dem Eingang 1 und dessen zweiter Eingang mit einem Prädiktor 3 beschaltet ist. Jedes Differenzsignal $\Delta$, das auch als Schätzfehler bezeichnet wird, wird in einem Quantisierer 4 quantisiert, wobei das sich ergebende, mit dem Quantisierungsfehler q behaftete Differenzsignal $\Delta_q = \Delta + q$ in einem Codierer 5 codiert und über einen Ausgang 6 dem Übertragungskanal zugeführt wird. Zur Bildung des Schätzwertes $\hat{s}$ ist ein rekursiver Signalpfad vorgesehen, der von einem Schaltungspunkt 7 ausgangsseitig vom Quantisierer 4 ausgeht, einen ersten Addierer 8, eine Begrenzereinrichtung 9 und den Prädiktor 3 enthält und an den zweiten Eingang des Subtrahierers 2 geführt ist. Der Ausgang des Prädiktors 3 ist weiterhin mit einem zweiten Eingang des ersten Addierers 8 verbunden, der durch Addition des quantisierten Differenzsignals $\Delta_q$ und des Schätzwertes $\hat{s}$ ein sog. rekonstruiertes Bildpunktsignal $s_R$ bildet. Für jedes aktuelle Bildpunktsignal s liefert der Prädiktor 3 aus wenigstens einem der vorhergegangenen Bildpunktsignale den Schätzwert $\hat{s}$.

Bezeichnet man gemäß Fig. 2 den in einem Fernsehbild m in der Zeile n liegenden, aktuellen Bildpunkt mit X, den unmittelbar vorher abgetasteten Bildpunkt mit A, den X entsprechenden Bildpunkt der vorhergehenden Zeile n-1 mit C und die dem letzteren benachbarten, unmittelbar vor bzw. nach diesem abgetasteten Bildpunkte mit B und D und bezeichnet man weiterhin die entsprechenden Bildpunkte des vorhergegangenen Bildes m-1 mit X' und A' bis D', so ergibt sich folgendes: Man kann zur Bildung des Schätzwertes $\hat{s}$ für das Bildpunktsignal von X die Bildpunktsignale von wenigstens einem der Punkte A bis D heranziehen, wobei man von einer zweidimensionalen (2D-) Prädiktion spricht. Verwendet man hierzu zusätzlich oder ausschließlich die Bildpunktsignale von wenigstens einem der Bildpunkte X' und A' bis D', so liegt eine dreidimensionale (3D-) Prädiktion vor. Im ersteren Falle kann der Schätzwert $\hat{s}$ beispielsweise nach der 2D-Schätzgleichung

$$\hat{s} = \alpha \cdot s_A + \beta \cdot s_B + \delta \cdot s_C + \delta \cdot s_D \qquad (1)$$

ermittelt werden, im letzteren Fall zum Beispiel nach der 3D-Schätzgleichung

$$\hat{s} = \alpha \cdot s_A + \beta \cdot s_X' \qquad (2)$$

wobei mit $s_A$ das rekonstruierte Bildpunktsignal des Bildpunktes A bezeichnet ist, mit $s_B$ das des Bildpunktes B usw. und wobei die Koeffizienten $\alpha$, $\beta$, $\gamma$ und $\delta$ Bewertungsfaktoren darstellen, die den einzelnen Bildpunktsignalen zugeordnet sind.

Der Erfindung liegt die Aufgabe zugrunde, eine Anordnung der eingangs genannten Art anzugeben, bei der eine schnelle Signalverarbeitung bei einer Minimalanzahl von Subtrahierern gewährleistet ist. Das wird erfindungsgemäß durch eine Ausbildung der Anordnung nach dem kennzeichnenden Teil des Patentanspruchs 1 und des Patentanspruchs 2 erreicht.

Der mit der Erfindung erzielbare Vorteil liegt insbesondere darin, daß der Schaltungsaufwand für die Parallelisierung der Begrenzerfunktion in einer DPCM-Schleife verringert wird und damit ein kompakterer Aufbau einer Anordnung zur DPCM-Codierung von Fernsehsignalen möglich ist. Die erfindungsgemäße Anordnung eignet sich sowohl zum Einsatz in 2D- als auch in 3D-DPCM-Codierungsverfahren. Sie läßt sich in relativ einfacher Weise in integrierter Schaltkreistechnik auf einem Halbleiterkörper realisieren.

Die Patentansprüche 3 bis 5 sind auf bevorzugte Ausgestaltungen und Weiterbildungen der Erfindung gerichtet.

Die Erfindung wird nachfolgend anhand von in der Zeichnung dargestellten, bevorzugten Ausführungsbeispielen näher erläutert. Dabei zeigt:

Fig. 1     das Prinzipschaltbild einer bekannten Anordnung zur DPCM-Codierung,

Fig. 2     eine Darstellung von einzelnen Bildpunkten zweier aufeinanderfolgender Fernsehbilder zur Erläuterung von Fig. 1,

Fig. 3     ein erstes Ausführungsbeispiel der Erfindung,

Fig. 4     eine Weiterbildung der Anordnung nach Fig. 3.

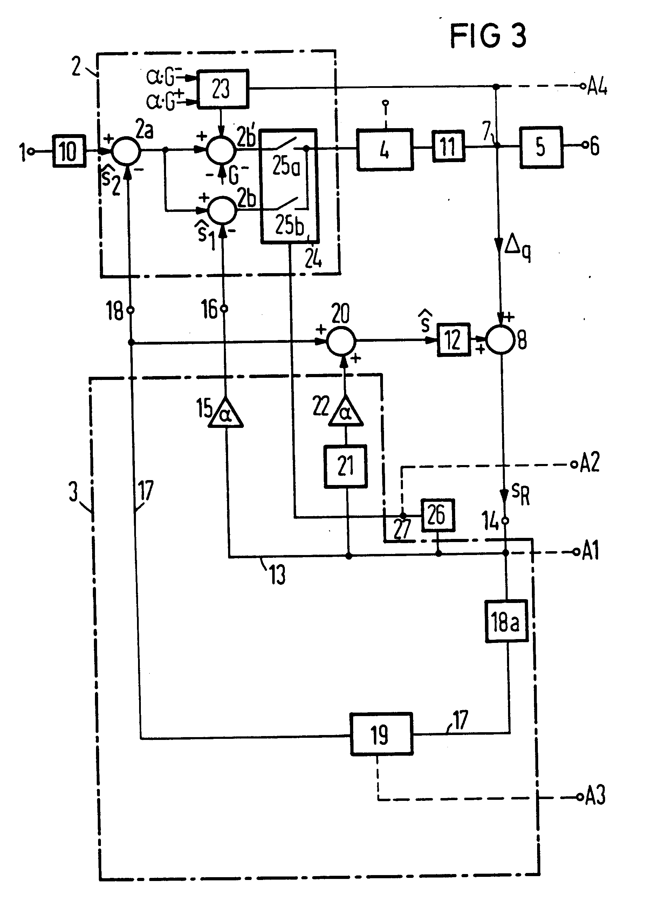

Fig. 3 zeigt eine Anordnung mit dem erfindungsgemäßen Subtrahierer 2, die von dem in Fig. 1 dargestellten Grundaufbau eines DPCM-Coders ausgeht. Zusätzlich zu den bereits anhand von Fig. 1 erläuterten, mit den gleichen Bezugszeichen versehenen Funktionseinheiten sind mit Taktimpulsspannungen beaufschlagte Register 10, 11 und 12 vorgesehen, von denen das Register 10 in Serie zum Eingang 1 liegt, das Register 11 zwischen den Schaltungsteilen 4 und 7 und das Register 12 vor dem zweiten Eingang des Addierers 8. Zu Beginn einer Taktimpulsperiode i seien im Register 10 ein aktuelles Bildpunktsignal s gespeichert, das z.B. dem Bildpunkt X entspricht, im Register 11 ein quantisiertes Differenzsignal $\Delta_q$, das vom Bildpunktsignal s der Periode i-1 und damit vom Bildpunkt A abgeleitet ist, und im Register 12 ein Schätzwert $\hat{s}$, der aus den Bildpunktsignalen einiger zeitlich davor liegender Taktimpulsperioden gebildet ist. Dabei besteht die Zeitbedingung, daß während der Taktimpulsperiode i im Addierer 8 ein rekonstruiertes Bildpunktsignal $s_R$ gebildet werden muß, im Prädiktor 3 ein neuer Schätzwert $\hat{s}$ zu ermitteln ist, im Subtrahierer 2 ein Differenzsignal $\Delta = s-\hat{s}$ zu bilden ist und im Quantisierer 4 ein quantisiertes Signal $\Delta_q$ abzuleiten ist, so daß bis zum Beginn der nächstfolgenden Taktimpulsperiode i + 1 das letztgenannte Signal bereits im Register 11 gespeichert worden ist. In der Taktimpulsperiode i + 1 wiederholt sich dann der Vorgang, wobei im Register 10 bereits das nächstfolgende Bildpunktsignal gespeichert ist. Es besteht also ein zeitkritischer Signalpfad, der vom Ausgang des Registers 11 über 7, 8, 3, 2 und 4 zum Eingang von 11 verläuft. Die Signalverarbeitung innerhalb dieses zeitkritischen Pfades muß innerhalb einer Taktimpulsperiode erfolgen.

Da der Prädiktor 3 in Fig. 3 nach einer 2D- oder 3D-Schätzgleichung entsprechend Beziehung (1) bzw. (2) arbeitet, weist er einen ersten Schaltungszweig 13 auf, der vom Eingang 14 über einen ersten Bewerter 15, der eine Signalbewertung mit einem Bewertungsfaktor $\alpha$ durchführt, zu einem ersten Ausgang 16 verläuft. An diesem ist ein erster, mit Hilfe des Bildpunktes A gewonnener Signalanteil $\hat{s}_1$ des Schätzwertes $\hat{s}$ abgreifbar. Ein zweiter Schaltungszweig 17 verläuft von 14 zu einem zweiten Ausgang 18 des Prädiktors und dient zur Ableitung eines zweiten, mit Hilfe der Bildpunkte B, C und D gewonnenen Signalanteils $\hat{s}_2$. Der Signalanteil $\hat{s}_2$ wird dabei über einen 2D- bzw. 3D-Prädiktor 19 ermittelt. Der Schätzwert $\hat{s}$ setzt sich anschließend aus beiden Signalanteilen $\hat{s}_1$ und $\hat{s}_2$ additiv zusammen.

Die Aufteilung des Schätzwertes $\hat{s}$ in die beiden Signalanteile $\hat{s}_1$ und $\hat{s}_2$ macht eine entsprechende Aufteilung des Subtrahierers 2 von Fig. 1 in zwei zueinander in Kette geschaltete Subtrahierer 2a und 2b erforderlich, wobei in 2a der Signalanteil $\hat{s}_2$ von dem im Register 10 gespeicherten Bildpunktsignal s abgezogen wird und der Signalanteil $\hat{s}_1$ seinerseits in 2b von der so gebildeten Differenz abgezogen wird. Aus den Signalanteilen $\hat{s}_2$ und $\hat{s}_1$ wird andererseits in einem Addierer 20 der Schätzwert $\hat{s}$ ermittelt, wobei $\hat{s}_1$ für diese Addition eigens über einen mit dem Eingang 14 verbundenen Begrenzer 21 und einen dem Bewerter 15 nachgebildeten Bewerter 22 abgeleitet wird. Der Ausgang des Addierers 20 ist mit dem Eingang des Registers 12 verbunden.

Neben dem Subtrahierer 2b ist in Fig. 3 ein weiterer Subtrahierer 2b′ vorgesehen, wobei die ersten Eingänge von 2b und 2b′ zueinander parallel geschaltet sind. Unter der Voraussetzung, daß einer der beiden im ersten Addierer 8 addierten Werte mit Sicherheit innerhalb des durch den unteren und oberen Grenzwert $G^-$, $G^+$ bestimmten Wertebereiches bleibt, kann die Zahl der parallel arbeitenden Subtrahierer 2b, 2b′ auf zwei begrenzt werden. Während der zweite Eingang von 2b mit dem Signalanteil $\hat{s}_1$ belegt ist, ist der zweite Eingang von 2b' mit einem Umschalter 23 verbunden, der mit einem mit $\alpha$ gewichteten unteren und oberen Grenzwert $\alpha.G^-$, $\alpha.G^+$ beaufschlagt ist. Der Umschalter 23 wird gesteuert vom höchstwertigen Bit (Vorzeichenbit, VZB) des Signals am ersten Eingang des Addierers 8, wenn das Signal an dessen zweitem Eingang mit Sicherheit im Bereich $G^-$, $G^+$ liegen wird, oder vom Vorzeichenbit des Signals am zweiten Eingang des ersten Addierers 8, wenn das Signal an dessen erstem Eingang den Wertebereich nicht verlassen wird (das bedeutet, das der Quantisierer 4 nur Werte innerhalb des Bereichs liefert). Eingezeichnet in Fig. 3 wurde die erste Möglichkeit, so daß der Schaltungspunkt 7 mit dem Umschalter 23 verbunden ist. Weist das Signal am ersten Eingang des ersten Addierers 8 ein positives Vorzeichen auf, so wird der obere Grenzwert $\alpha.G^+$ auf den zweiten Eingang des weiteren Subtrahierers 2b' geschaltet, weist es ein negatives Vorzeichen auf, wird der untere Grenzwert $\alpha.G^-$ auf den zweiten Eingang von 2b' gelegt. Bleibt beispielsweise der Wert des Signals am zweiten Eingang des ersten Addierers 8 mit Sicherheit in dem vorgegebenen Wertebereich, so gibt das Vorzeichen des Signals am ersten Eingang des ersten Addierers 8 das Vorzeichen eines möglichen Überlaufs an. Haben die Signale am ersten und zweiten Eingang des ersten Addierers 8 das gleiche Vorzeichen, so tritt entweder kein Überlauf auf oder der Überlauf hat das gleiche Vorzeichen wie das Signal am ersten Eingang des ersten Addierers 8. Haben die Signale am ersten und zweiten Eingang des ersten Addierers 8 unterschiedliche Vorzeichen, so tritt kein Überlauf auf, wenn der Betrag des Signals am ersten Eingang des ersten Addierers 8 kleiner ist als der Betrag des Signals am zweiten Eingang. Ist der Betrag des Signals am ersten Eingang des ersten Addierers 8 jedoch größer als der Betrag des Signals am zweiten Eingang desselben Addierers, so hat ein dann möglicher Überlauf das Vorzeichen vom Signal am ersten Eingang des ersten Addierers 8. Da nun das Vorzeichen des möglichen Überlaufs schon bei Beginn der Operation bekannt ist, kann sich die Parallelisierung auf einen Pfad mit Überlauf und auf einen für keinen Überlauf beschränken. Der Überlaufpfad rechnet mit dem oberen Grenzwert $\alpha.G^+$, falls das Signal am ersten Eingang des ersten Addierers 8 positiv ist und mit dem unteren Grenzwert $\alpha.G^-$, wenn das zuletzt genannte Signal negativ ist. Die Ausgänge der Subtrahierer 2b und 2b' sind daher an die Eingänge eines Multiplexers 24 gelegt, dessen Ausgang mit dem Eingang des Quantisierers 4 verbunden ist. Eine Überlauferkennungseinrichtung 26, die mit dem Ausgang des Addierers 8 verbunden ist, steuert über ihren Ausgang 27 den Multiplexer 24. Dabei wird für den Fall, daß die im Addierer 8 gebildete Summe den vorgegebenen, positiven oder negativen Grenzwert $G^+$, $G^-$ übersteigt, vom Ausgang 27 ein Steuersignal abgegeben, das den Schalter 25a schließt und den Ausgang des Subtrahierers 2b' mit dem Eingang des Quantisierers 4 verbindet. Schließlich wird für den Fall, daß die in 8 gebildete Summe sich innerhalb des durch $G^+$ und $G^-$ bestimmten Wertebereiches befindet, der Schalter 25b geschlossen, so daß die in 2b gebildete Differenz an den Eingang von 4 gelangt.

Da der Bewerter 15 in Serie zu dem zweiten Eingang des digitalen Subtrahierers 2b angeordnet ist, kann eine Bewertung mit einem Faktor $\alpha$, der durch eine Zahl $2^n$ (n = 1, 2 usw. oder -1, -2 usw.) ausgedrückt wird, in einfacher Weise dadurch realisiert werden, daß das zu bewertende Signal, in diesem Fall das rekonstruierte Bildpunktsignal $s_R$, welches z. B. aus acht Bits besteht, nicht den Eingängen der ihm stellenmäßig entsprechenden Stufen des Subtrahierers 2b zugeführt wird, sondern den um eine entsprechende Stellenzahl in Richtung auf höherwertige oder niedrigerwertige Bits versetzten Stufeneingängen. Entsprechendes gilt auch für den Bewerter 22, dessen Funktion ebenfalls durch eine versetzte Zuordnung der einzelnen Bits der zu bewertenden digitalen Signale zu den Stufeneingängen des Addierers 20 realisiert werden kann.

Der Ausgang des Addierers 8 ist direkt mit dem zweiten Eingang des Subtrahierers 2b verbunden. Die in 8 gebildete Summe kann daher bitweise, und zwar beginnend mit der Stufe niedrigster Wertigkeit, entsprechend dem Übertragsdurchlauf an die einzelnen Stufeneingänge des Subtrahierers 2b angelegt werden. Die Subtraktion läuft also nahezu parallel zur Addition ab und ist nur um die Signallaufzeit vom Eingang bis zum Summenausgang der Stufe der niedrigsten Wertigkeit des Addierers 8 verzögert. Die Funktion der Begrenzereinrichtung 9 in Fig. 1 wird nun dadurch realisiert, daß in 2b und 2b' unabhängig voneinander zwei Differenzbeträge gebildet werden, von denen jeweils nur einer an den Quantisierer 4 durchgeschaltet wird. Die Entscheidung, welche der zwei Differenzen weiterverarbeitet wird, trifft die Überlauferkennungseinrichtung 26. In entsprechender Weise wird die im Subtrahierer 2a gebildete Differenz den ersten Eingängen der Subtrahierer 2b und 2b' bitweise, und zwar beginnend mit der Stufe niedrigster Wertigkeit, zugeführt, so daß auch die in 2a und 2b durchgeführten Subtraktionen nahezu gleichzeitig erfolgen.

Durch die nach der Erfindung realisierte Begrenzerfunktion wird die Signalverarbeitung im genannten rekursiven Signalpfad gegenüber der Signalverarbeitung nach Fig. 1 wesentlich beschleunigt, da dort erst nach Ablauf der vollen Arbeitszeit des Addierers 8 eine Begrenzung des Summensignals in der Einrichtung 9 erfolgen kann und der Subtrahierer 2 erst im Anschluß hieran die Differenz zwischen dem Bildpunktsignal s und dem gegebenenfalls begrenzten Summensignal des Addierers 8 ermittelt.

Der Begrenzer 21 läßt zwar keine fast gleichzeitige Summenbildung in den Addierern 8 und 20 zu, doch liegt er in einem vom Ausgang des Registers 12 über 8, 21, 22 und 20 zum Eingang von 12 verlaufenden Signalpfad, der nicht zeitkritisch ist, da in ihm keine Signalquantisierung vorgenommen wird.

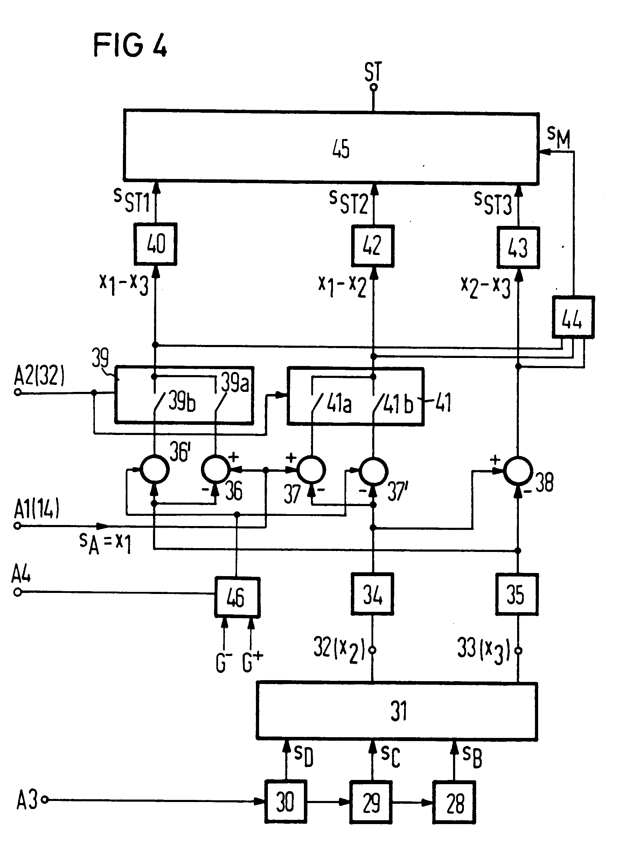

Fig. 4 zeigt eine Teilschaltung, die die Anordnung nach Fig. 3 zu einem DPCM-Coder mit adaptiver Quantisierung ergänzt. Dabei wird davon ausgegangen, daß der Quantisierer 4 auf eine von mehreren Quantisierungskennlinien umschaltbar ist, die sich insbesondere dadurch unterscheiden, daß jeweils unterschiedlich große Quantisierungsschritte verwendet werden. Ist der Kontrast eines zu codierenden Bildpunktes, z.B. X, zu den ihn umgebenden Bildpunkten nur gering und damit der zu erwartende Schätzfehler klein, so erfolgt die Quantisierung in kleinen Stufen, während bei größeren Kontrastwerten auf Quantisierungskennlinien mit jeweils größeren Quantisierungsstufen umgeschaltet wird. Der Quantisierer 4 ist mit einem Steuereingang ST versehen, dem Steuersignale zugeführt werden, die eine Umschaltung auf eine jeweils ausgewählte Quantisierungskennlinie bewirken. Die in Figur 4 dargestellte Teilschaltung stellt dabei eine Steuerschaltung dar, über die ein dem Eingang ST zugeführtes Steuersignal abgeleitet wird.

Die Steuerschaltung nach Fig. 4 weist vier Eingänge auf, die jeweils mit den Ausgängen A1, A2, A3 und A4 der Anordnung nach Fig. 3 verbunden sind und daher die gleichen Bezugszeichen tragen. Der Eingang A1 entspricht dem Schaltungspunkt 14 von Fig. 3, der Eingang A2 dem Ausgang 27 der Überlauferkennungseinrichtung 26, der Eingang A3 dem Ausgang des Verzögerungsgliedes 19 und der Eingang A4 dem ersten Eingang des ersten Addierers 8. Über A3 werden die von den Bildpunkten B, C und D abgeleiteten, rekonstruierten Bildpunktsignale $s_B$, $s_C$ und $s_D$ nacheinander drei in Serie zueinander liegenden Registern 28 bis 30 zugeführt und in diesen gespeichert. Diese Bildpunktsignale werden zunächst in einer Vergleichseinrichtung 31 derart miteinander verglichen, daß an einem ersten Ausgang 32 von 31 das größte dieser drei Bildpunktsignale erscheint, das mit $x_2$ bezeichnet wird, und an einem zweiten Ausgang 33 von 31 das kleinste dieser drei Signale, das mit $x_3$ bezeichnet wird. In nachgeschalteten Registern 34 und 35 werden die Signale $x_2$ und $x_3$ gespeichert. Über den Eingang A1 wird das vom Bildpunkt A abgeleitete, rekonstruierte Bildpunktsignal $s_A$ zugeführt, das im folgenden mit $x_1$ bezeichnet wird.

Man bildet nun die Differenzsignale $x_1$-$x_3$, $x_1$-$x_2$ und $x_2$-$x_3$. Dazu sind drei Subtrahierer 36, 37 und 38 vorgesehen, wobei die ersten Eingänge von 36 und 37 mit dem Eingang A1 verbunden sind und die zweiten Eingänge dieser Subtrahierer jeweils an den Ausgängen der Register 35 und 34 liegen. Der erste Eingang des Subtrahierers 38 ist mit dem Ausgang des Registers 34 beschaltet, der zweite Eingang von 38 mit dem Ausgang des Registers 35. Der Ausgang von 36 ist über einen Multiplexer 39 an den Eingang einer Logikschaltung 40 geführt, die das Differenzsignal $x_1$-$x_3$ in eine von mehreren Amplitudenklassen einordnet und in Abhängigkeit von der Klasse, in die das Differenzsignal eingeordnet wurde, ein klassenspezifisches Steuersignal $s_{ST1}$ abgibt. Nimmt man an, daß z.B. drei verschiedene Grenzwerte GW1 bis GW3 definiert sind, die vier verschiedene Amplitudenklassen begrenzen, so wird für den Fall, daß $x_1$-$x_3$ unterhalb von GW1 liegt, ein erstes Steuersignal $s_{ST1}$ abgegeben, das eine erste Quantisierungskennlinie des Quantisierers 4 auswählt. Liegt $x_1$-$x_3$ zwischen GW1 und GW2, so ergibt sich ein zweites Steuersignal $s_{ST1}$, das eine zweite Quantisierungskennlinie auswählt. Gehört $x_1$-$x_3$ einer Klasse an, deren Grenzen durch GW2 und GW3 gegeben sind, so wird eine dritte Quantisierungskennlinie ausgewählt, während die Zugehörigkeit des Differenzsignals zu der oberhalb von GW3 liegenden, vierten Klasse eine Auswahl der vierten Quantisierungskennlinie bedingt.

In analoger Weise wird das im Subtrahierer 37 gebildete Differenzsignal $x_1$-$x_2$ über einen Multiplexer 41 dem Eingang einer Logikschaltung 42 zugeführt, die je nach Zugehörigkeit dieses Differenzsignals zu einer der vorstehend genannten Amplitudenklassen ein klassenspezifisches Steuersignal $s_{ST2}$ abgibt. Weiterhin gelangt das Differenzsignal $x_2$-$x_3$ an den Eingang einer Logikschaltung 43, in der ein klassenspezifisches Steuersignal $s_{ST3}$ in der bereits beschriebenen Weise erzeugt wird. Eine Auswahlsteuerung 44 leitet aus den Vorzeichenbits der Differenzsignale $x_1$-$x_3$, $x_1$-$x_2$ und $x_2$-$x_3$ ein Steuersignal $s_M$ ab, das angibt, welches dieser Differenzsignale das größte ist. $s_M$ wird sodann einem Multiplexer 45 zugeführt, der in Abhängigkeit von $s_M$ nur eines der Steuersignale $s_{ST1}$, $s_{ST2}$ oder $s_{ST3}$ an den Eingang ST des Quantisierers 4 durchschaltet, und zwar dasjenige, das von dem größten der drei zuletzt genannten Differenzsignale abgeleitet worden ist.

Mit einer solchen Steuerschaltung, die prinzipiell bereits aus der DE-A 33 31 426 bekannt ist, wird in Abhängigkeit von dem maximalen Kontrast, der zwischen jeweils zwei Bildpunkten innerhalb der Bildpunktgruppe A, B, C und D auftritt, eine diesem maximalen Kontrast zugeordnete Quantisierungskennlinie des Quantisierers 4 ausgewählt. Der Aufbau und die Funktionsweise der Vergleichseinrichtung 36, der Logikschaltungen 40, 42 und 43 und der Auswahlsteuerung 44 sind der DE-OS 33 31 426 zu entnehmen.

Die Begrenzungsfunktion, die innerhalb des zeitkritischen Pfades 7, 8, 15, 2, 4 und 11 (Fig. 3) durch den parallel zu 2b arbeitenden Subtrahierer 2b′, den Multiplexer 24 und die Überlauferkennungseinrichtung 26 realisiert wird, ist in der Steuerschaltung nach Fig. 4 dadurch realisiert, daß neben dem Subtrahierer 36 ein weiterer Subtrahierer 36′ vorgesehen ist, wobei die zweiten Eingänge dieser Subtrahierer zueinander parallel geschaltet sind. Der erste Eingang von 36′ ist über einen Umschalter 46 mit dem Eingang A4 der Steuerschaltung verbunden. Analog wie in der erfindungsgemäßen Schaltung nach Fig. 3 ist dieser Eingang A4 mit dem ersten Eingang des ersten Addierers 8 verschaltet, falls am zweiten Eingang des ersten Addierers 8 das Eingangssignal mit Sicherheit im Bereich $G^-$ bis $G^+$ liegt. Ist jedoch der Wertebereich am ersten Eingang des ersten Addierers 8 auf $G^-$ bis $G^+$ festgelegt, so ist der Eingang A4 der Steuerschaltung nach Fig. 4 mit dem zweiten Eingang des ersten Addierers 8 zu verschalten. Auch hierbei wird der Umschalter 46 vom höchstwertigen Bit, das dem Vorzeichenbit des jeweiligen Signals entspricht, gesteuert. Der Umschalter 46 ist wiederum mit einem unteren und einem oberen Grenzwert $G^-$, $G^+$ beaufschlagt, wobei jeweils einer in Abhängigkeit von dem Vorzeichen des Signals am ersten Eingang des ersten Addierers 8 (Fig. 3) auf den ersten Eingang des Subtrahierers 36′ durchgeschaltet wird. Weist das betreffende Signal ein positives Vorzeichen auf, so wird der obere Grenzwert $G^+$ auf den ersten Eingang des Subtrahierers 36′ weitergeleitet, weist es hingegen ein negatives Vorzeichen auf, wird der untere Grenzwert $G^-$ auf den betreffenden Eingang des Subtrahierers 36′ gelegt. Die Ausgänge von 36, 36′ sind an zugeordnete Eingänge des Multiplexers 39 gelegt, der über Schalter 39a oder 39b nur einen der Subtrahiererausgänge an den Eingang der Logikschaltung 40 durchschaltet. In analoger Weise ist dem Subtrahierer 37 ein weiterer Subtrahierer 37′ zugeordnet, wobei jeweils einer der Ausgänge der Subtrahierer 37 oder 37′ über einen der Schalter 41a oder 41b des Multiplexers 41 an den Eingang der Logikschaltung 42 durchgeschaltet wird und der erste Eingang des weiteren Subtrahierers 37′ ebenfalls an den Umschalter 46 angeschlossen ist. Die Steuerung der Schalter 39a und 39b und 41a bis 41b erfolgt in Abhängigkeit von dem Ausgangssignal der Überlauferkennungseinrichtung 26, das über den Eingang A2 zugeführt wird. Bleibt $s_A$ innerhalb des durch $G^+$ and $G^-$ bestimmten Wertebereichs, so werden die Schalter 39a und 41a geschlossen. Überschreitet dagegen das Bildpunktsignal $s_A$ den positiven Grenzwert $G^+$ oder negativen Grenzwert $G^-$, so schließen die Schalter 39b und 41b. Trotz aufrechterhaltener Begrenzungs- funktion innerhalb des rekursiven Schaltungszwei- ges 7, 8, A1, 36 (37), 39 (41) 40 (42), 45, 4 und 11 wird hierdurch eine schnelle Steuerung des Quantisierers 4 erreicht, da eine nahezu gleichzeitige Addition im Addierer 8 und Subtraktion in den Subtrahierern 36, 36′ und 37, 37′ erfolgt.

## Patentansprüche

1. Anordnung zur DPCM-Codierung von Fernsehsignalen, bei der von digitalisierten Bildpunktsi- gnalen (s) jeweils Schätzwerte $(\hat{s})$ subtrahiert und die erhaltenen Differenzsignale nach einer Quantisierung und Codierung zur Signalübertragung herangezogen werden, mit einem rekursiven Signalpfad, der einen ersten Addierer (8) zur Bildung von rekonstruierten Bildpunktsignalen $(s_R)$ aus den quantisierten Differenzsignalen und den Schätzwerten, eine Begrenzereinrichtung, einen Prädiktor (3) zur Bildung der Schätzwerte $(\hat{s})$ und eine Subtraktionsvorrich- tung (2) zur Bildung der Differenzsignale aufweist, wobei die Subtraktionsvorrichtung (2), zwei Subtrahierer (2b, 2b′) und einen Multiplexer (24) enthält, daß die Ausgänge der zwei Subtrahierer über einen Multiplexer (24) mit dem Eingang eines die Quantisierung durchführenden Quantisierers (4) verbunden sind, wobei ein Steuereingang des Multiplexers mit einer vom Ausgang des ersten Addierers (8) gesteuerten Überlauferkennungseinrichtung (26) beschaltet ist, **dadurch gekennzeichnet,** daß die zwei Subtrahierer (2b, 2b′) mit parallel geschalteten ersten Eingängen mit den Bildpunktsignalen oder von diesen über einen vor- geschalteten Subtrahierer (2a) abgeleiteten Si- gnalen beschaltet sind, daß der zweite Eingang des ersten Subtrahierers (2b) der Subtraktionsvorrichtung (2) mit dem Ausgang des ersten Addierers (8) verbunden ist, daß der zweite Eingang des zweiten Subtrahierers (2b′) der Subtraktionsvorrichtung (2) mit einem Umschalter (23) verbunden ist, daß der Umschalter (23) mit einem mit $\alpha$ gewichteten unteren Grenzwert ($\alpha.G^-$) und einem mit $\alpha$ gewichteten oberen Grenzwert ($\alpha.G^+$) des ersten Addierers (8) beaufschlagt ist, daß falls Signale an einem zweiten Eingang des ersten Addierers (8) innerhalb eines von $G^-$ bis $G^+$ gebildeten Wertebereichs liegen, der Umschalter (23) mit einem ersten Eingang des ersten Addierers (8) verschaltet ist, daß der Umschalter (23) in Abhängigkeit vom Vorzeichen eines Signals am ersten Eingang des ersten Addierers (8) den unteren oder oberen Grenzwert ($G^-$, $G^+$) auf den zweiten Eingang des zweiten Subtrahierers (2b') schaltet.

2. Anordnung zur DPCM-Codierung von Fernsehsignalen, bei der von digitalisierten Bildpunktsignalen (s) jeweils Schätzwerte ($\hat{s}$) subtrahiert und die erhaltenen Differenzsignale nach einer Quantisierung und Codierung zur Signalübertragung herangezogen werden, mit einem rekursiven Signalpfad, der einen ersten Addierer (8) zur Bildung von rekonstruierten Bildpunktsignalen ($s_R$) aus den quantisierten Differenzsignalen und den Schätzwerten, eine Begrenzereinrichtung, einen Prädiktor (3) zur Bildung der Schätzwerte ($\hat{s}$) und eine Subtraktionsvorrichtung (2) zur Bildung der Differenzsignale aufweist, wobei die Subtraktionsvorrichtung (2), zwei Subtrahierer (2b, 2b') und einen Multiplexer (24) enthält, daß die Ausgänge der zwei Subtrahierer über einen Multiplexer (24) mit dem Eingang eines die Quantisierung durchführenden Quantisierers (4) verbunden sind, wobei ein Steuereingang des Multiplexers mit einer vom Ausgang des ersten Addierers (8) gesteuerten Überlauferkennungseinrichtung (26) beschaltet ist, **dadurch gekennzeichnet,** daß die zwei Subtrahierer (2b, 2b') mit parallel geschalteten ersten Eingängen mit den Bildpunktsignalen oder von diesen über einen vorgeschalteten Subtrahierer (2a) abgeleiteten Signalen beschaltet sind, daß der zweite Eingang des ersten Subtrahierers (2b) der Subtraktionsvorrichtung (2) mit dem Ausgang des ersten Addierers (8) verbunden ist, daß der zweite Eingang des zweiten Subtrahierers (2b') der Subtraktionsvorrichtung (2) mit einem Umschalter (23) verbunden ist, daß der Umschalter (23) mit einem mit α gewichteten unteren Grenzwert (α.G$^-$) und einem mit α gewichteten oberen Grenzwert (α.G$^+$) des ersten Addierers (8) beaufschlagt ist, daß falls Signale an einem ersten Eingang des ersten Addierers (8) innerhalb eines von G$^-$ bis G$^+$ gebildeten Wertebereichs liegen, der Umschalter (23) mit einem zweiten Eingang des ersten Addierers (8) verschaltet ist, daß der Umschalter (23) in Abhängigkeit vom Vorzeichen eines Signals am zweiten Eingang des ersten Addierers (8) den unteren oder oberen Grenzwert (G$^-$, G$^+$) auf den zweiten Eingang des zweiten Subtrahierers (2b') schaltet.

3. Anordnung nach Anspruch 1 oder 2, **dadurch gekennzeichnet,** daß der vorgeschaltete Subtrahierer (2a) über seinen ersten Eingang mit den digitalisierten Bildpunktsignalen (s) beschaltet ist, daß der zweite Eingang desselben über einen 2D- oder 3D-Prädiktor (19) und einen ersten Begrenzer (18a) mit dem Ausgang des ersten Addierers (8) verbunden sind, und daß der zweite Eingang des vorgeschalteten Subtrahierers (2a) mit dem ersten Eingang eines ersten zusätzlichen Addierers (20) beschaltet ist, dessen zweiter Eingang über einen zweiten Begrenzer (21) mit dem Ausgang des ersten Addierers (8) verbunden ist und dessen Ausgang mit dem zweiten Eingang des ersten Addierers (8) beschaltet ist.

4. Anordnung nach Anspruch 3, **dadurch gekennzeichnet,** daß der Quantisierer (4) auf unterschiedliche Quantisierungskennlinien umschaltbar ausgebildet ist, daß von einem der Verzögerungsglieder (19) drei rekonstruierte Bildpunktsignale ($s_B$, $s_C$ und $s_D$) ableitbar sind, daß eine Vergleichseinrichtung (31) vorgesehen ist, in der das größte dieser drei Bildpunktsignale ($x_2$) und das kleinste derselben ($x_3$) selektiert werden, daß ein rekonstruiertes, aktuelles Bildpunktsignal ($x_1$) am Ausgang des ersten Addierers (8) abgegriffen wird, daß die Differenzbeträge aus dem aktuellen Bildpunktsignal und dem genannten größten Bildpunktsignal ($x_1$-$x_2$), aus dem aktuellen Bildpunktsignal und dem genannten kleinsten Bildpunktsignal ($x_1$-$x_3$) und aus dem genannten größten und dem genannten kleinsten Bildpunktsignal ($x_2$-$x_3$) ermittelt werden, daß für jeden dieser Differenzbeträge eine Logikschaltung (40, 42, 43) vorgesehen ist, in der die Zuordnung zu einer Mehrzahl von Grenzwerten und den hierdurch definierten Amplitudenklassen ermittelt und ein dieser Zuordnung entsprechendes klassenspezifisches Steuersignal ($s_{ST1}$, $s_{ST2}$, $s_{ST3}$) gebildet wird, daß dasjenige der klassenspezifischen Steuersignale, das zu dem größten der drei Differenzbeträge ($x_1$-$x_2$, $x_1$-$x_3$, $x_2$-$x_3$) gehört, über einen zweiten Multiplexer (45) einen Steuereingang des Quantisierers (4) beaufschlagt, so daß eine diesem klassenspezifischen Steuersignal zugeordnete Quantisierungskennlinie ausgewählt wird, daß neben dem den Differenzbetrag aus dem aktuellen Bildpunktsignal ($x_1$) und dem kleinsten der genannten Bildpunktsignale ($x_3$) bildenden Subtrahier (36) noch ein weiterer Subtrahierer (36') vorgesehen ist, wobei in diesem weiteren Subtrahierer in Abhängigkeit vom Vorzeichen eines Signals am Eingang des Umschalters (23) jeweils die Differenz zwischen dem oberen bzw. unteren Grenzwert (G$^+$, G$^-$) des ersten Addierers (8) und dem kleinsten der genannten Bildpunktsignale ($x_3$) gebildet wird, daß ein von der Überlauferkennungseinrichtung (26) gesteuerter dritter Multiplexer (39) vorgesehen ist, der lediglich eines der in den zwei zuletzt genannten Subtrahierern gebildeten Ergebnisse als den Differenzbetrag zwischen dem aktuellen Bildpunktsignal und dem genannten kleinsten Bildpunktsignal ($x_1$-$x_3$) an die nachgeordnete Logikschaltung (40) weitergibt, daß neben dem den Differenzbetrag aus dem aktuellen Bildpunktsignal und dem größten der genannten Bildpunktsignale ($x_1$-$x_2$) bildenden Subtrahierer (37) noch ein zusätzlicher Subtrahierer (37') vorgesehen ist, wobei in diesen letzteren in Abhängigkeit vom Vorzeichen eines Signals am Eingang des Umschalters (23) jeweils die Differenz zwischen dem oberen bzw. unteren Grenzwert ($G^+$, $G^-$) des ersten Addierers (8) und dem größten der genannten Bildpunktsignale ($x_2$) gebildet wird, und daß ein von der Überlauferkennungseinrichtung (26) gesteuerter vierter Multiplexer (41) vorgesehen ist, der lediglich eines der in den zwei zuletzt genannten Subtrahierern gebildeten Ergebnisse als den Differenzbetrag zwischen dem aktuellen Bildpunktsignal und dem genannten größten Bildpunktsignal ($x_1$-$x_2$) an die nachgeordnete Logikschaltung (42) weitergibt.

5. Anordnung nach Anspruch 4, **dadurch gekennzeichnet,** daß der zweite Multiplexer (45) über eine Auswahlsteuerung (44) gesteuert wird, die mit den Vorzeichen der den Logikschaltungen (40, 42 und 43) zugeführten Differenzbeträge beaufschlagt ist.

**Claims**

1. Arrangement for the DPCM coding of television signals, in which in each case estimated values ($\hat{s}$) are subtracted from digitised pixel signals (s) and the difference signals obtained are utilised for signal transmission after quantisation and coding, comprising a recursive signal path which exhibits a first adder (8) for forming reconstructed pixel signals ($s_R$) from the quantised difference signals and the estimated values, a limiter device, a predictor (3) for forming the estimated values ($\hat{s}$) and a subtraction device (2) for forming the difference signals, the subtraction device (2) containing two subtractors (2b, 2b') and a multiplexer (24), the outputs of the two subtractors being connected via a multiplexer (24) to the input of a quantiser (4) carrying out the quantization, an overflow detection device (26) controlled by the output of the first adder (8) being connected to one control input of the multiplexer, characterised in that the pixel signals or signals derived from these via a preceding subtractor (2a) are connected to parallel-connected first inputs of the two subtractors (2b, 2b'), in that the second input of the first subtractor (2b) of the subtraction device (2) is connected to the output of the first adder (8), in that the second input of the second subtractor (2b') of the subtraction device (2) is connected to a change-over switch (23), in that a lower limit value ($\alpha.G^-$), weighted with $\alpha$, and an upper limit value ($\alpha.G^+$), weighted with $\alpha$, of the first adder (8) are applied to the change-over switch (23), in that, if signals at a second input of the first adder (8) are within a range of values formed from $G^-$ to $G^+$, the change-over switch (23) is connected to a first input of the first adder (8), and in that the change-over switch (23) switches the lower or upper limit value ($G^-$, $G^+$) to the second input of the second subtractor (2b') in dependence on the sign of a signal at the first input of the first adder (8).

2. Arrangement for the DPCM coding of television signals, in which in each case estimated values ($\hat{s}$) are subtracted from digitised pixel signals (s) and the difference signals obtained are utilised for signal transmission after quantization and coding, comprising a recursive signal path which exhibits a first adder (8) for forming reconstructed pixel signals ($s_R$) from the quantised difference signals and the estimated values, a limiter device, a predictor (3) for forming the estimated values ($\hat{s}$) and a subtraction device (2) for forming the difference signals, the subtraction device (2) containing two subtractors (2b, 2b') and a multiplexer (24), the outputs of the two subtractors being connected via a multiplexer (24) to the input of a quantiser (4) carrying out the quantization, an overflow detection device (26) controlled by the output of the first adder (8) being connected to one control input of the multiplexer, characterised in that the pixel signals or signals derived from these via a preceding subtractor (2a) are connected to parallel-connected first inputs of the two subtractors (2b, 2b'), in that the second input of the first subtractor (2b) of the subtraction device (2) is connected to the output of the first adder (8), in that the second input of the second subtractor (2b') of the subtraction device (2) is connected to a change-over switch (23), in that a lower limit value ($\alpha.G^-$), weighted with $\alpha$, and an upper limit value ($\alpha.G^+$), weighted with $\alpha$, of the first adder (8) is applied to the change-over switch (23), in that, if signals at a first input of the first adder (8) are within a range of values formed from $G^-$ to $G^+$, the change-over switch (23) is connected to a second input of the first adder (8), and in that the change-over switch (23) switches the lower or upper limit value ($G^-$, $G^+$) to the second input of the second subtractor ($2b'$) in dependence on the sign of a signal at the second input of the first adder (8).

3. Arrangement according to Claim 1 or 2, characterised in that the digitized pixel signals (s) are connected to the first input of the preceding subtractor ($2a$), that the second input of this subtractor is connected to the output of the first adder (8) via a 2D or 3D predictor (19) and a first limiter ($18a$), and in that the second input of the preceding subtractor ($2a$) is connected to the first input of a first additional adder (20), the second input of which, is connected to the output of the first adder (8) via a second limiter (21), and the output of which, is connected to the second input of the first adder (8).

4. Arrangement according to Claim 3, characterised in that the quantiser (4) is constructed to be switchable to different quantization characteristics, in that three reconstructed pixel signals ($s_B$, $s_C$ and $s_D$) can be derived from one of the delay sections (19), in that a comparison device (31) is provided in which the greatest of these three pixel signals ($x_2$) and the smallest of these ($x_3$) are selected, in that a reconstructed current pixel signal ($x_1$) is picked up at the output of the first adder (8), in that the difference amounts from the current pixel signal and the said greatest pixel signal ($x_1$-$x_2$) are determined from the current pixel signal and the said smallest pixel signal ($x_1$-$x_3$) and from the said greatest and the said smallest pixel signal ($x_2$-$x_3$), in that for each of these difference amounts, a logic circuit (40, 42, 43) is provided in which the correlation with a plurality of limit values and the amplitude classes defined thereby is determined and a class-specific control signal ($s_{ST1}$, $s_{ST2}$, $s_{ST3}$) corresponding to this correlation is formed, in that the one of the class-specific control signals which belongs to the greatest of the three difference amounts ($x_1$-$x_2$, $x_1$-$x_3$, $x_2$-$x_3$) is applied via a second multiplexer (45) to a control input of the quantiser (4) so that a quantization characteristic allocated to this class-specific control signal is selected, in that, in addition to the subtractor (36) forming the difference amount from the current pixel signal ($x_1$) and the smallest one of the said pixel signals ($x_3$), a further subtractor ($36'$) is provided, wherein in this further substractor in each case the difference between the upper and, respectively, lower limit value ($G^+$, $G^-$) of the first adder (8) and the smallest one of the said pixel

signals ($x_3$) is formed in dependence on the sign of a signal at the input of the change-over switch (23), in that a third multiplexer (39) controlled by the overflow detection device (26) is provided which only forwards one of the results, formed in the two last-mentioned subtractors, as the difference amount between the current pixel signal and the said smallest pixel signal ($x_1$-$x_3$) to the subsequent logic circuit (40), in that, apart from the subtractor (37) forming the difference amount from the current pixel signal and the greatest one of the said pixel signals ($x_1$-$x_2$), another additional subtractor ($37'$) is provided, wherein in these substractors in each case the difference between the upper and, respectively, lower limit value ($G^+$, $G^-$) of the first adder (8) and the greatest one of the said pixel signals ($x_2$) is formed in dependence on the sign of a signal at the input of the change-over switch (23), and in that a fourth multiplexer (41) controlled by the overflow detection device (26) is provided which only forwards one of the results, formed in the two last-mentioned subtractors, as the difference amount between the current pixel signal and the said greatest pixel signal ($x_1$-$x_2$) to the subsequent logic circuit (42).

5. Arrangement according to Claim 4, characterised in that the second multiplexer (45) is controlled via a selection control (44) to which the signs of the difference amounts supplied to the logic circuits (40, 42 and 43) are supplied.

**Revendications**

1. Dispositif pour le codage MICD de signaux de télévision, dans lequel respectivement des valeurs estimées (s) sont soustraites de signaux de points d'image numérisés (s) et les signaux de différence obtenus sont utilisés, après une quantification et un codage, pour la transmission de signaux, et comportant une voie récursive de transmission de signaux, qui comporte un premier additionneur (8) servant à former des signaux de points d'image reconstitués ($s_R$) à partir des signaux quantifiés de différence et des valeurs estimées, un dispositif limiteur, un dispositif de prédiction (3) pour former les valeurs estimées (s) et un dispositif de soustraction (2) pour former les signaux de différence, le dispositif de soustraction (2) contenant deux soustracteurs ($2b$,$2b'$) et un multiplexeur (24), que les sorties des deux soustracteurs sont raccordées par l'intermédiaire d'un multiplexeur (24) à l'entrée d'un quantificateur (4) exécutant la quantification, une entrée de commande du multiplexeur étant raccordée à un dispositif (26) d'identification d'un dépassement de capacité, commandé par la sortie du premier additionneur (8), caractérisé par le fait que des premières entrées branchées en parallèle des deux soustracteurs (2b,2b') reçoivent des signaux de points d'image ou des signaux dérivés de ces signaux par l'intermédiaire d'un dispositif de soustraction (2a) branché en amont, que la seconde entrée du premier soustracteur (2b) du dispositif de soustraction (2) est raccordée à la sortie du premier additionneur (8), que la seconde entrée du soustracteur (2') du dispositif de soustraction (2) est raccordée à un commutateur (23), que le commutateur (23) est chargé par une valeur limite inférieure ($\alpha.G^-$) pondéré par $\alpha$ et par une valeur limite supérieure ($\alpha.G^+$) pondérée par $\alpha$, du premier additionneur (8), que dans le cas où des signaux sont appliqués à la seconde entrée du premier additionneur (8) dans une gamme de valeurs allant de $G^-$ à $G^+$, le commutateur (23) est raccordé à la première entrée du premier additionneur (8), et qu'en fonction d'un signal présent sur la première entrée du premier additionneur (8), le commutateur (23) applique la valeur limite inférieure ou supérieure ($G^-$, $G^+$), à la seconde entrée du second soustracteur (2b').

2. Dispositif pour le codage MICD de signaux de télévision, dans lequel respectivement des valeurs estimées (s) sont soustraites de signaux de points d'image numérisés (s) et les signaux de différence obtenus sont utilisés après une quantification et un codage pour la transmission de signaux, et comportant une voie récursive de transmission de signaux, qui comporte un premier additionneur (8) servant à former des signaux de points d'image reconstitués ($s_R$) à partir des signaux quantifiés de différence et des valeurs estimées, un dispositif limiteur, un dispositif de prédiction (3) pour former les valeurs estimées (s) et un dispositif de soustraction (2) pour former les signaux de différence, le dispositif de soustraction (2) contenant deux soustracteurs (2b,2b') et un multiplexeur (24), que les sorties des deux soustracteurs sont raccordées, par l'intermédiaire d'un multiplexeur (24), à l'entrée d'un quantificateur (4) exécutant la quantification, une entrée de commande du multiplexeur étant raccordée à un dispositif (26) d'identification d'un dépassement de capacité, commandé par la sortie du premier additionneur (8), caractérisé par le fait que des premières entrées branchées en parallèle des deux soustracteurs (2b,2b') sont chargées par les signaux de points d'image ou par des signaux dérivés de ces derniers, par l'intermédiaire d'un soustracteur (2a) branché en amont, que la seconde entrée du premier soustracteur (2b) du dispositif de soustraction (2) est raccordée à la sortie du premier additionneur (8), que la seconde entrée du second soustracteur (2b') du dispositif de soustraction (2) est raccordée à un commutateur (3), que le commutateur (23) est chargé par une valeur limite inférieure ($\alpha.G^-$) pondérée par $\alpha$ et par une valeur limite supérieure ($\alpha.G^+$) pondérée par $\alpha$ du premier additionneur (8), que dans le cas où des signaux appliqués à une première entrée du premier additionneur (8) sont situés dans une gamme de valeurs allant de $G^-$ à $G^+$, le commutateur (23) est raccordé à une seconde entrée du premier additionneur (8), qu'en fonction du signal présent sur la seconde entrée du premier additionneur (8), le commutateur (23) applique la valeur limite inférieure ou supérieure ($G^-$, $G^+$) à la seconde entrée du second soustracteur (2b').

3. Dispositif suivant la revendication 1 ou 2, caractérisé par le fait que le soustracteur (2a) branché en amont reçoit, par l'intermédiaire de sa première entrée, des signaux de points d'image numérisés (s), que la seconde entrée de ce commutateur est raccordée, par l'intermédiaire d'un dispositif de prédiction 2D ou 3D (19) et d'un premier limiteur (18a), à la sortie du premier additionneur (8), que la seconde entrée du soustracteur (2a) branché en amont est raccordée à la première entrée d'un premier additionneur supplémentaire (20), dont la seconde entrée est raccordée à la sortie du premier additionneur (8) par l'intermédiaire d'un second limiteur (21) et dont la sortie est raccordée à la seconde entrée du premier additionneur (8).

4. Dispositif suivant la revendication 3, caractérisé par le fait que le quantificateur (4) est agencé de manière à être commutable sur différentes courbes caractéristiques de quantification, que trois signaux de points d'image ($s_B$, $s_C$ et $s_D$) peuvent être dérivés de l'un des circuits de retardement (19), qu'il est prévu un dispositif comparateur (31), dans lequel le plus intense de ($x_2$) et le plus faible ($x_3$) de ces signaux de points d'image sont sélectionnés, qu'un signal de point d'image actuel reconstitué ($x_1$) est prélevé sur la sortie du premier additionneur (8), que les valeurs de différence entre le signal de point d'image actuel et ledit signal de point d'image plus intense, à savoir ($x_1-x_2$), et entre le signal de point d'image actuel et ledit signal de point d'image le plus faible, à savoir ($x_1$ - $x_3$), et entre ledit signal de point d'image le plus intense et ledit signal de point d'image le plus faible, à savoir ($x_2$ - $x_3$), sont déterminées, que pour chacune de ces valeurs de différence, il est prévu un circuit logique (40,42,43), dans lequel l'association à une multiplicité de valeurs limites et aux classes d'amplitudes définies de ce fait, est déterminée, et un signal de commande ($s_{ST1}$, $s_{ST2}$, $s_{ST3}$) correspondant à cette association spécifique à une classe est formé, que celui des signaux de commande spécifiques aux classes, qui est associé à la plus grande des trois valeurs de différence ($x_1$ - $x_2$, $x_1$ - $x_3$, $x_2$ - $x_3$) est appliqué, par l'intermédiaire d'un second multiplexeur (45), à une entrée de commande du quantificateur (4) de sorte qu'une courbe caractéristique de quantification associée à ce signal de commande spécifique à une classe, est sélectionnée, qu'en plus du soustracteur (36) qui forme la valeur de différence entre le signal de point d'image actuel ($x_1$) et le plus faible desdits signaux de points d'image ($x_3$), il est en outre prévu un autre soustracteur (36'), dans lequel est formée, en fonction du signe d'un signal appliqué à l'entrée du commutateur (23), respectivement la différence entre la valeur limite supérieure ou inférieure ($G^+$, $G^-$) du premier additionneur (8) et le plus faible desdits signaux de points d'image ($x_3$), qu'il est prévu un troisième multiplexeur (39), qui est commandé par le dispositif (26) d'identification de dépassement de capacité, qui retransmet au circuit logique (40) branché en aval, seulement l'un des résultats formés dans les deux soustracteurs indiqués en dernier lieu, en tant que valeur de différence entre le signal de point d'image actuel et ledit signal de point d'image le plus faible, à savoir ($x_1$ - $x_3$), qu'en plus du soustracteur (37) qui forme la valeur de différence entre le signal de point d'image actuel et le plus intense desdits signaux de points d'image, à savoir ($x_1$ - $x_2$), il est en outre prévu un soustracteur supplémentaire (37'), dans lequel est formée, en fonction du signe d'un signal appliqué à l'entrée du commutateur (23), respectivement la différence entre la valeur limite supérieure ou inférieure ($G^+$, $G^-$) du premier additionneur (8) et le plus intense desdits signaux de points d'image ($x_2$), et qu'il est prévu un quatrième multiplexeur (41) qui est commandé par le dispositif (26) d'identification d'un dépassement de capacité et qui retransmet au circuit logique (42) branché en aval, simplement l'un des résultats formés dans les deux soustracteurs indiqués en dernier lieu, en tant que valeur de différence entre le signal de point d'image actuel et ledit signal de point d'image le plus intense, à savoir ($x_1$-$x_2$).

**5.** Dispositif suivant la revendication 4, caractérisé par le fait que le second multiplexeur (45) est commandé par l'intermédiaire d'une unité de commande de sélection (44), qui est chargée par le signe des valeurs de différences envoyées aux circuits logiques (40,42,43).

# FIG 1

# FIG 2

# FIG 3

FIG 4